# EUROPÄISCHE PATENTANMELDUNG

(11) **EP 2 239 793 A1**
(43) Veröffentlichungstag der Anmeldung: **13.10.2010**
(21) Anmeldenummer: 09005280.4
(22) Anmeldetag: 11.04.2009
(51) Int. Cl.: H01L 41/09, F15D 1/12, G06F 1/16

(54) **Elektrisch schaltbarer Polymerfilmaufbau und dessen Verwendung**

(71) Anmelder: Bayer MaterialScience AG, 51368 Leverkusen (DE)
(72) Erfinder: Buesgen, Thomas, 51065 Köln (DE); Jenninger, Werner, 50674 Köln (DE); Wagner, Joachim, 51061 Köln (DE); Pfeiffer, Evelyn, 51375 Leverkusen (DE); Maier, Gerhard, 80807 München (DE); Gärtner, Robert, 82296 Schöngeising (DE)

(57) **Zusammenfassung**

Die vorliegende Erfindung betrifft einen elektrisch schaltbaren Polymerfilmaufbau (1), der eine erste und eine zweite Oberflächenseite aufweist, umfassend mindestens ein Elektrodenpaar (3,4) und eine Polymermatrix (2) wobei in der Polymermatrix (2) strukturgebende Partikel (5) eingebettet sein können und die Polymermatrix oder die strukturgebenden Partikel aus einem elektroaktiven Polymer bestehen, wobei weiterhin durch eine elektrische Schaltung des elektroaktiven Polymers die erste und/oder zweite Oberflächenseite von einem glatten Zustand in einen strukturierten Zustand überführbar ist. Zudem betrifft die Erfindung eine Oberflächenbeschichtung umfassend einen erfindungsgemäßen elektrisch schaltbaren Polymerfilmaufbau sowie deren Verwendung.

## Beschreibung

Die vorliegende Erfindung betrifft elektrisch schaltbare Polymerfilmaufbauten, bei denen durch eine elektrische Schaltung eines elektroaktiven Polymers eine erste und/oder zweite Oberflächenseite des Polymerfilmaufbaus aktiv von einem glatten Zustand in einen strukturierten Zustand überführt wird. Die Erfindung betrifft weiterhin die Verwendung solcher elektrisch schaltbaren Polymerfilmaufbauten.

Eine Oberflächenstruktur aktiv zu beeinflussen, ist von hohem technischem Interesse für verschiedene Anwendungen wie zum Beispiel veränderbare Haptik, optische Eigenschaften oder die Beeinflussung des Strömungsverhaltens von Fluiden. Durch vorteilhafte und gezielt einstellbare Eigenschaften, wie zum Beispiel geringes Gewicht und einstellbare mechanische Eigenschaften, werden Polymere und Polymerverbundstoffe bereits in einer Vielzahl von kommerziellen Anwendungen eingesetzt. Funktionspolymere gewinnen dabei in zunehmendem Maße als aktive Komponenten in Sensor- oder Aktoranwendungen an Bedeutung. In den letzten Jahren steht in diesem Zusammenhang zunehmend die Klasse der elektroaktiven Polymere (EAP) im Interesse der Forschung.

In den Offenlegungsschriften US 2008/0128027 A1 und der WO 2008/105861 A2 werden Systeme und Methoden zur Deformation von Oberflächen beschrieben, um die Strömung von Fluiden entlang dieser gezielt zu beeinflussen. Dadurch können zum Beispiel Turbulenzen vermieden oder Resonanzschwingungen erzeugt oder vernichtet werden. Als Aktoren werden unter anderem mikroelektromechanische Systeme, piezoelektrische Wandler, elektroaktive Polymere, magnetische oder hydraulische Aktoren genannt. Die Aktoren wirken dabei senkrecht zur Oberfläche und werden über ein Kontrollsystem gesteuert.

Ein Flächenaktor mit mehreren Aktorelementen, die aus Formgedächtnisdrähten und/oder piezoelektrischen Elementen gefertigt sind, wird in der EP 1 090 835 A1 vorgestellt. Diese Flächenaktoren können zur gezielten Beeinflussung einer Strömung entlang einer Oberfläche genutzt werden. Trotz des geringen Verhältnisses zwischen Aktorlänge und erzielbarem Hub und der Anordnung der Drähte parallel zur Oberfläche wird eine kleine Verformung erreicht, die durch eine federnde und anisotrop versteifte Flächenstruktur verstärkt werden kann. Zusätzlich wird eine Oberflächenstrukturierung durch Rillen oder Schlitze in Wirkrichtung der Aktorelemente vorgeschlagen, um die Verformung durch die Aktoren weiter zu steigern.

Die DE 100 26 264 A1 offenbart eine bewegliche Gestaltung von Fahrzeug-Außenhäuten, wobei eine Vielzahl eng benachbarter, elektrisch betätigbarer Aktoren in Form kleiner Zylinder in die Außenhaut derart eingebettet werden, dass die Oberfläche der Aktoren im Ausgangszustand bündig mit der Außenhaut verlaufen und durch Schalten eine Noppenstruktur generieren. Diese Noppenstruktur soll oberhalb einer bestimmten Geschwindigkeit den Luftwiderstand verringern und Windgeräusche vermindern oder aber zum Lösen von Eis und Schnee von der Außenhaut ausgenutzt werden. Dazu werden als Materialien für die Aktorelemente polymere und/oder ionenaustauschende Materialien vorgeschlagen, die eine Formänderung durch elektrische Prozesse oder durch Änderung des pH-Wertes, der Feuchtigkeit oder der Temperatur vollziehen.

Eine weitere Möglichkeit, eine Oberflächenstrukturierung zu generieren, ist in der WO 2005/079187 A2 beschrieben. Diese besteht darin, die elektrostatische Anziehung zwischen plattenförmigen Elektroden auszunutzen. Zwischen den Elektroden befindet sich ein dielektrisches Elastomer, auf das bei Anlegen einer Spannung eine Kraft durch die sich gegenseitig anziehenden Elektroden ausgeübt wird. Das Elastomer wird dann zwischen den Elektroden herausgedrückt, wodurch die Oberfläche in diesem Bereich eine Vertiefung aufweist. Außerhalb der Elektroden wird das verdrängte Polymer aufgeworfen und aus der Oberflächenebene herausgedrückt. Durch diesen Prozess entstehen Vertiefungen und Erhöhungen, die durch eine vorgegebene Elektrodenanordnung und Beschaltung zu einer bestimmten Oberflächenstrukturierung führen können. Als Anwendungen werden dreidimensionale und im speziellen Braille-Displays, bewegliche Spiegel, Strömungsbeeinflussung an Flügeln, Schrittmotoren und Pumpen genannt.

In der Patentschrift US 7,397,166 B1 wird eine Peristaltik-Pumpe beschrieben, bei der die Verformung von Aktoren aus einem Polymer-Metall-Komposit bei angelegter Spannung ausgenutzt wird und durch eine Anordnung voneinander separierter Elektroden entlang der Längsrichtung eines flexiblen Schlauchs eine Flüssigkeitsmenge innerhalb des Schlauches durch sukzessives Schalten der Elektroden transportiert werden kann. Als Beispiel für eine Anwendung wird der Transport von flüssigen Medikamenten im menschlichen Körper genannt.

Die elektroaktiven Polymere (EAP) können grundsätzlich in zwei Hauptgruppen unterteilt werden. Die erste Gruppe ist die der so genannten feldaktivierten Polymere. Unter feldaktivierten EAP werden typischerweise solche Polymere, Polymermischungen und Polymer-Komposite verstanden, welche direkt durch Anlegen eines elektrischen Feldes geschaltet werden können. Sie erfordern elektrische Felder von bis zu 200 V·µm⁻¹. Ein Vorteil der Gruppe der feldaktivierten EAP ist, dass sie in der Regel mit Geschwindigkeiten im Millisekundenbereich geschaltet werden können. Zu den feldaktivierten Polymeren werden dielektrische Elastomere, ferroelektrische Polymere, piezoelektrische Polymere und elektrostriktive Polymere gezählt.

Die zweite Hauptgruppe der EAP sind die so genannten ionischen elektroaktiven Polymere. Diese Gruppe zeichnet sich dadurch aus, dass sie auf einem Wirkmechanismus basiert, der eine Diffusion von Ionen und/oder von solvatisierten Ionen und/oder von Lösungsmittelmolekülen involviert. Beispiele von polymeren Materialien, die zu den ionischen EAP gezählt werden, sind Polymere oder Polymer-Komposite, die bewegliche Ionen enthalten, leitfähige Polymere, ionische Gele und Polymer-Komposite mit Kohlenstoffnanoröhrchen und/oder Graphenen.

Die grundsätzlichen Typen und Wirkmechanismen der verschiedenen elektroaktiven Polymere (EAP) sind unter anderem in den Artikeln im MRS Bulletin, March 2008, Volume 33, No. 3 und der jeweils darin zitierten Literatur beschrieben.

Die ionischen EAP sind meist an ein flüssiges Medium, zum Beispiel an einen Elektrolyten, gebunden und daher oft von den Umgebungsbedingungen wie Temperatur und relativer Luftfeuchte abhängig. Ohne weitere Maßnahmen können sie an Luft mit der Zeit austrocknen und so ihre Funktionalität als EAP verlieren. Daher sind EAP-Systeme von Interesse, welche die Abhängigkeit von den Umgebungsbedingungen reduzieren. Eine Möglichkeit besteht darin, ionische Flüssigkeiten (engl.: ionic liquid, IL) als Elektrolytlösung in einer Polymermatrix zu verwenden, so dass das Gesamtsystem aus Polymermatrix und ionischer Flüssigkeit ein Festkörper ist. Die IL sind organische Salze, die bei Raumtemperatur im geschmolzenen Zustand vorliegen, einen vernachlässigbar kleinen Dampfdruck besitzen und somit ein Austrocknen und den Funktionsverlust von ionischen EAP verhindern können.

Funktionelle Polymere und Polymerfilmaufbauten sind für kommerzielle Anwendungen, beispielsweise für Sensor- und Aktorsysteme, sowie zur aktiven Beeinflussung von Oberflächen und Oberflächeneigenschaften von zunehmendem Interesse.

Erfindungsgemäß wird daher ein elektrisch schaltbarer Polymerfilmaufbau vorgeschlagen, der eine erste und eine zweite Oberflächenseite aufweist, die einander gegenüberliegend angeordnet sind. Der Polymerfilmaufbau umfasst mindestens ein Elektrodenpaar mit Anode und Kathode und eine Polymermatrix, wobei in der Polymermatrix strukturgebende Partikel angeordnet sein können.

Das Vorhandensein strukturgebender Partikel kann erfindungsgemäß bevorzugt sein. Es können aber auch Ausführngsformen erfindungsgemäß bevorzugt sein, in denen keine solchen strukturgebenden Partikel enthalten sind.

Die Polymermatrix und/oder die gegebenenfalls vorhandenen strukturgebenden Partikel bestehen aus einem elektroaktiven Polymer. Durch eine elektrische Schaltung des elektroaktiven Polymers kann die erste und/oder zweite Oberflächenseite des erfindungsgemäßen Polymerfilmaufbaus von einem glatten Zustand in einen strukturierten Zustand überführt werden.

Mit anderen Worten kann durch Anlegen einer elektrischen Spannung an einen erfindungsgemäßen Polymerfilmaufbau vorteilhafterweise auf mindestens einer Oberflächenseite aktiv eine strukturierte Oberfläche mit Erhebungen und Vertiefungen erzeugt werden. Diese Strukturierung mindestens einer Oberflächenseite des Polymerfilmaufbaus ist reversibel und kann durch weitere elektrische Schaltungen vorteilhafterweise wiederholt hervorgerufen werden. Die Polymermatrix ist erfindungsgemäß als Polymerfilm ausgebildet.

Die aktiv beeinflussbare Oberflächenseite des erfindungsgemäßen Polymerfilmaufbaus kann zum Beispiel genutzt werden, um haptisch wahrnehmbare Signale zu erzeugen und die aktiv erzeugbare Aufrauung durch die elektrische Schaltung in vielfältigen Anwendungen einzusetzen. Ein weiterer Vorteil ist, dass durch die elektrische Schaltung eines erfindungsgemäßen Polymerfilmaufbaus auch optische Effekte erzielt werden können. Zum Beispiel kann der Polymerfilmaufbau im ungeschalteten, glatten Zustand transparent und nach dem Anlegen einer Spannung opak sein.

Gleichermaßen bevorzugt können nach der Erfindung die Polymerfilmaufbauten in alternativen Ausführungsformen als elektroaktives Polymer (EAP) ein feldaktiviertes oder ein ionisches elektroaktives Polymer enthalten.

Beispielsweise kann dabei ein feldaktiviertes Polymer aus dielektrischen Elastomeren, ferroelektrischen Polymeren, elektrostriktiven Polymeren und piezoelektrischen Polymeren ausgewählt werden.

Als ferroelektrisches und piezoelektrisches Polymer können erfmdungsgemäß beispielsweise Poly(Vinylidenfluorid) (PVDF) und Copolymere des VDF, beispielsweise Copolymere von VDF mit Trifluoroethylen, eingesetzt werden. Die dielektrischen Elastomere können erfindungsgemäß beispielsweise Silikone, Polyurethane, Polyacrylate, Kautschuke, Styrol-Ethylen-Butylen-Styrol (SEBS) oder Styrol-Butadien-Kautschuk sein.

Das ionische elektroaktive Polymer kann erfindungsgemäß beispielsweise ausgewählt werden aus Polymeren, die bewegliche Ionen enthalten, aus leitfähigen Polymeren, aus ionischen Gelen und aus Polymer-Kompositen mit Kohlenstoffnanoröhrchen und/oder Graphenen.

Ein Beispiel für ein ionisches Gel ist Poly(vinylalkohol)gel mit Dimethylsulfoxid. Erfindungsgemäß einsetzbare leitfähige Polymere sind zum Beispiel Polypyrrole, Polyanilline und Polythiophene.

Geeignete EAP-Materialien und ihre Wirkmechanismen sind grundsätzlich bekannt und beispielsweise im Artikel von Y. Bar-Cohen, Q. Zhang, S. 173-181, MRS Bulletin, March 2008, Volume 33, No. 3, sowie in der dort zitierten Literatur beschrieben.

Durch die vielfältigen alternativen Auswahlmöglichkeiten bezüglich des EAP kann vorteilhafterweise die Einstellung der grundsätzlichen Eigenschaften des erfindungsgemäßen schaltbaren Polymeraufbaus und eine spezielle Anpassung auf bestimmte Anwendungen ermöglicht werden. Erfindungsgemäß können gute Schaltbarkeiten und Oberflächenstrukturierungen der ersten und/oder zweiten Oberflächenseite des erfindungsgemäßen Polymerfilmaufbaus erzielt werden.

Der erfindungsgemäße Polymerfilmaufbau, umfassend mindestens ein Elektrodenpaar, eine Polymermatrix und gegebenenfalls darin eingebettete strukturgebende Partikel, kann in ungeschaltetem glatten Zustand, also ohne eine angelegte Spannung, eine Dicke von ≥10µm und ≤1mm , bevorzugt eine Dicke von ≥50 bis ≤500 µm, besonders bevorzugt von ≥100 bis ≤300 µm aufweisen. Eine besonders geeignete Dicke des Polymerfilmaufbaus kann dabei vorteilhafterweise jeweils in Abhängigkeit des konkret eingesetzten Materials für die Polymermatrix und für die Partikel, insbesondere im Hinblick auf das oder die gewählten EAP, sowie im Hinblick auf die jeweils angestrebte Anwendung ausgewählt werden.

Es ist erfindungsgemäß vorteilhafterweise möglich, die Ausprägung der Strukturierung durch verschiedenste Parameter zu beeinflussen. Exemplarisch für solche Parameter seien die Stärke des angelegten elektrischen Feldes, die Dimensionierung, Form und Strukturierung der Elektroden, Größe und Volumenanteil der Partikel und die Dicke der Polymermatrix genannt.

In einer weiteren Ausgestaltung des erfindungsgemäßen elektrisch schaltbaren Polymerfilmaufbaus können die Elektroden, also die Anode und die Kathode, auf einander gegenüberliegenden Oberflächen der Polymermatrix angeordnet sein, wobei eine Oberflächenseite des Polymerfilmaufbaus als flexible Deckelektrode und die jeweils andere Oberflächenseite als starre Basiselektrode ausgebildet ist. Mit anderen Worten ergibt sich der erfindungsgemäße Polymeraufbau in dieser Ausgestaltung als Schichtaufbau aus einer flächig ausgestalteten Basiselektrode unten, einem darauf aufgebrachten Polymermatrixfilm mit darin angeordneten strukturgebenden Partikeln und einer auf dieser Polymermatrix aufgebrachten flächigen flexiblen Deckelektrode.

Als Deckelektrode wird im Sinne der Erfindung eine Elektrode bezeichnet, die auf der Oberflächenseite des Polymerfilmaufbaus angeordnet ist, die durch die Schaltung des elektroaktiven Polymers in einen strukturierten Zustand überführt werden kann. Unter Basiselektrode wird dagegen erfindungsgemäß eine Elektrode verstanden, die auf einer Oberflächenseite des Polymerfilmaufbaus angeordnet ist, die durch die elektrische Schaltung nicht strukturiert wird.

Die Begriffe oben, unten, unterhalb und oberhalb beziehen sich in der Beschreibung der Erfindung nur auf die Lage der Bestandteile relativ zueinander und sind gegebenenfalls austauschbar zu verwenden. Unter flexibler Deckelektrode wird erfindungsgemäß verstanden, dass diese Elektrode so ausgestaltet ist, dass sie die Formänderungen und Strukturgebung, die sich durch die Schaltung des elektroaktiven Polymers insbesondere auf der Oberfläche der Polymermatrix ergibt, übernehmen und abbilden kann. Auf diese Weise bildet die Deckelektrode dann beim Anlegen einer geeigneten Spannung eine nach außen gerichtete strukturierte Oberflächenseite des Polymerfilmaufbaus.

Bei den Elektroden, sowohl der Deckelektrode als auch der Basiselektrode, kann es sich um dem Fachmann bekannte leitfähige Materialien handeln. Erfindungsgemäß kommen hierfür beispielsweise Metalle, Metall-Legierungen, leitfähige Oligo- oder Polymere, wie z.B.Polythiophene, Polyaniline, Polypyrrole, leitfähige Oxide, wie zum Beispiel Mischoxide wie ITO, oder mit leitfähigen Füllstoffen gefüllte Polymere in Frage. Als Füllstoffe für mit leitfähigen Füllstoffen gefüllte Polymere kommen beispielsweise Metalle, leitfähige Kohlenstoff basierte Materialien, wie z.B. Russ, Kohlenstoffnanoröhrchen (Carbonanotubes (CNTs)), oder wiederum leitfähige Oligo- oder Polymere, in Frage. Der Füllstoffgehalt der Polymere liegt dabei oberhalb der Perkolationsschwelle, so dass die leitfähigen Füllstoffe durchgehende elektrisch leitfähige Pfade ausbilden.

Die Elektroden können durch an sich bekannte Verfahren, beispielsweise durch eine Metallisierung der Oberflächen, durch Sputtern, Aufdampfen, Chemical Vapor Deposition (CVD), Physical Vapor Deposition (PVD), Drucken, Rakeln, Spin-Coaten, Aufkleben oder Aufdrücken einer leitenden Schicht in vorgefertigter Form oder durch eine Sprühelektrode aus einem leitenden Kunststoff realisiert werden.

In einer weiteren Ausführungsform des erfindungsgemäßen Polymerfilmaufbaus können die Elektroden auf einander gegenüberliegenden Oberflächen der Polymermatrix angeordnet sein, wobei die Elektroden an einer oder beiden Oberflächenseiten des Polymerfilmaufbaus strukturiert angeordnet sind. Auch in dieser Ausgestaltung des Polymerfilmaufbaus ist die Polymermatrix als Polymerfilm zwischen den Elektroden angeordnet, wobei unter strukturierter Elektrode im Sinne der Erfindung verstanden wird, dass die eine der Elektroden oder beide ein regelmäßiges oder unregelmäßiges Muster auf der jeweiligen Oberflächenseite des Polymerfilmaufbaus bilden. Die Elektroden können beispielsweise in Streifen oder in Gitterform, ausgestaltet sein. Die Elektroden können dabei alternativ auf der Oberfläche der Polymermatrix aufgebracht oder mindestens teilweise in die Polymermatrix eingelassen sein. Die Elektroden können auch vollständig in die Polymermatrix eingelassen sein. Die Elektroden können dann mit der Oberfläche der jeweils dazwischen angeordneten Polymermatrix bündig abschließen und mit dieser zumindest im ungeschalteten Zustand eine glatte Oberflächenseite des Polymerfilmaufbaus bilden.

In einer anderen Ausgestaltung des erfindungsgemäßen Polymerfilmaufbaus können die Elektroden als Basiselektroden an der ersten oder an der zweiten Oberflächenseite strukturiert angeordnet sein. Anode und Kathode befinden sich in dieser erfindungsgemäßen Variante an der gleichen Oberflächenseite des Polymerfilmaufbaus. Die andere, den Elektroden abgewandte, Oberflächenseite wird in dieser Ausgestaltung von der Polymermatrix gebildet. Auch in dieser Ausgestaltung können die Elektroden alternativ auf der Oberfläche der Polymermatrix aufgebracht oder mindestens teilweise in die Polymermatrix eingelassen sein. Die Elektroden können auch vollständig in Polymermatrix eingelassen sein. Die Elektroden können dann mit der Oberfläche der jeweils dazwischen angeordneten Polymermatrix bündig abschließen und mit dieser zumindest im ungeschalteten Zustand eine glatte Oberflächenseite des Polymerfilmaufbaus bilden. Diese glatte Oberflächenseite, die also zusammen aus Elektrodenoberflächen und Polymermatrixoberflächen gebildet wird, kann beispielsweise auf einem Substrat aufgebracht sein.

Unter strukturierter Anordnung der Basiselektroden wird im Sinne der Erfindung auch für diese Ausführungsform verstanden, dass die Anoden und Kathoden ein regelmäßiges oder unregelmäßiges Muster an einer der beiden Oberflächenseiten des Polymerfilmaufbaus bilden. Beispielsweise können bei einer gemeinsamen Aufbringung auf einer Oberflächenseite die Anoden und Kathoden alternierend angeordnet sein. Eine Möglichkeit, dies auf einfache Weise zu realisieren, ist die Verwendung von so genannten Kammelektroden, die interdigitierend und ineinandergreifend angeordnet werden können. Vorteilhafterweise können hierdurch die einzelnen gleich gepolten Elektroden gemeinsam geschaltet werden.

Sind die Elektroden strukturiert als Basiselektroden auf einer Oberflächenseite des Polymerfilmaufbaus angeordnet, kann in einer weiteren Ausführungsform vorgesehen sein, dass die Polymermatrix aus einem ionischen elektroaktiven Polymer besteht und keine strukturgebenden Partikel in der Polymermatrix angeordnet sind. Bevorzugt besteht die Polymermatrix in dieser Ausführungsform aus einem Elastomer, welches bewegliche Ionen enthält. Mit anderen Worten wird der Polymerfilm des elektrisch schaltbaren Polymerfilmaufbaus in dieser erfindungsgemäßen Ausführungsform aus einem ionenhaltigen Polymer-Komposit gebildet, in dem mindestens eine Ionensorte, Anionen oder Kationen, frei beweglich ist. Die Ionen können zum Beispiel in Form einer ionischen Flüssigkeit in die Elastomermatrix eingebracht werden. Wird eine Spannung angelegt, wandern die frei beweglichen Ionen zu den entsprechenden Elektroden. Je nachdem, ob nur eine oder beide Ionensorten (Anionen, Kationen) in der Polymermatrix beweglich sind, können in Folge der Ionendiffusion bei angelegtem elektrischen Feld dann die Bereiche um eine oder beide Elektrodenarten (Anode, Kathode) anschwellen und können so die Elektrodenstruktur auf der Oberflächenseite abbilden. Die Bereiche zwischen den Elektroden verarmen an Ionen, wodurch eine Volumenkontraktion resultieren kann, die den Unterschied zu den Erhebungen um die entsprechenden Elektroden noch vergrößert. So kann auf einfache Weise eine strukturierte Oberflächenseite des Polymerfilmaufbaus ausgebildet werden.

Eine andere Ausführungsform der Erfindung sieht vor, dass die Polymermatrix aus einem elektroaktiven Polymer besteht und die strukturgebenden Partikel elektrisch nicht-leitende Hartstoffpartikel sind. Besonders bevorzugt können die nicht-leitenden Hartstoffpartikel aus Glas, Keramik oder einem polymeren, elektrisch nicht-leitfähigem Material bestehen. Unter Hartstoffpartikel werden im Sinne der Erfindung Partikel verstanden, die ihre Form und Dimension während der elektrischen Schaltung beibehalten. Bei elektrischer Schaltung des Polymerfilmaufbaus können so Größe, Form und Verteilung der Partikel auf die Oberflächenseite mit der flexiblen Deckelektrode übertragen werden. Beispielsweise kann in einer kombinierten Ausführungsform mit einer flächig ausgebildeten starren Basiselektrode und einer flächig ausgebildeten flexiblen Deckelektrode und einer dazwischen angeordneten elektroaktiven Polymermatrix aus einem dielektrischen Elastomer, beim Anlegen einer Spannung die Polymermatrix zusammengedrückt werden, während die Partikel ihre Form beibehalten. Die Form und Verteilung der Partikel kann dann an der Oberflächenseite mit der Deckelektrode durch Erhebungen abgebildet werden.

Eine alternative Ausführungsform der Erfindung sieht vor, dass die strukturgebenden Partikel aus einem elektroaktiven Polymer bestehen und die Polymermatrix aus einem Elastomer gebildet wird. Die schaltbaren strukturgebenden Partikel sind Partikel, die bei elektrischer Schaltung eine reversible Form- und/oder Volumenänderung vollziehen können. Durch diese Eigenschaft können die Partikel ihre Form und Verteilung beispielsweise an die elastische Polymermatrix und gegebenenfalls an eine flexible Deckelektrode übertragen, wodurch sich eine strukturierte Oberflächenseite ausbilden kann. Dies hat den Vorteil, dass der eigentliche Polymerfilm nur hinsichtlich seiner Steifigkeit so abgestimmt werden muss, dass er bei elektrischer Schaltung des Polymerfilmaufbaus die Formänderung der strukturgebenden Partikel übernehmen kann. Daher kommen für die Polymermatrix vorteilhafterweise schon bekannte Lacksysteme in Frage, die bezüglich ihrer sonstigen Eigenschaften, wie Glanz, Abriebfestigkeit, Langzeitbeständigkeit oder Verarbeitbarkeit etc. bereits auf mögliche konkrete technische Anwendungen abgestimmt sind.

Wird alternativ das erfindungsgemäße Konzept mit strukturiert angeordneten Basiselektroden eingesetzt, können die schaltbaren Partikel aus elektroaktivem Polymer in der Nähe einer Elektrodenart anschwellen oder ihre Form ändern, während diese an den entgegengesetzt gepolten Elektroden unverändert bleiben oder schrumpfen. Die Größe und Durchmesser der Partikel wird auf die Dicke der Polymermatrix zweckmäßigerweise derart abgestimmt, dass die Form und/oder Volumenänderung der Partikel durch die elektrische Schaltung auf die den Basiselektroden gegenüberliegenden Oberflächenseite übertragen wird, so dass die entstehenden Erhebungen die Elektrodenstrukturierung und die Verteilung der Partikel wiedergibt.

In den erfindungsgemäßen Ausführungsformen in denen strukturgebende Partikel aus elektroaktiven Polymeren, also schaltbare Partikel eingesetzt werden, können diese eine der Elektroden berühren. In diesem Fall kann also mit anderen Worten ein elektrischer Kontakt der einzelnen Partikel mit einer Elektrode gegeben sein, der gegebenenfalls einen Austausch von Elektronen ermöglicht. Eine Elektrode kann dabei mit mehreren Partikeln in Berührung stehen.

Der erfindungsgemäße elektrisch schaltbare Polymerfilmaufbau kann mit den beschriebenen Varianten als freitragender Polymerfilmaufbau realisiert werden.

Erfindungsgemäß kann in einer anderen bevorzugten Ausgestaltung die erste oder die zweite Oberflächenseite des elektrisch schaltbaren Polymerfilmaufbaus auf einem Substrat aufgebracht sein, wobei die jeweils andere Oberflächenseite durch die elektrische Schaltung des elektroaktiven Polymers strukturiert werden kann. Das Substrat kann vorteilhafterweise als Träger und Stützkörper des Polymerfilmaufbaus dienen. Das Substrat kann weiterhin auch ein Gegenstand sein, auf den der erfindungsgemäße Polymerfilmaufbau als Oberflächenbeschichtung aufgebracht wird.

Die Erfindung umfasst darüber hinaus die Verwendung eines erfindungsgemäßen Polymerfilmaufbaus. Insbesondere betrifft die Erfindung eine elektrisch schaltbare Oberflächenbeschichtung umfassend einen erfindungsgemäßen elektrisch schaltbaren Polymerfilmaufbau in den vorstehend beschriebenen Varianten und Ausführungsformen. Diese Oberflächenbeschichtung kann beispielsweise auf Gegenständen, wie zum Beispiel Autokarosserien oder einem Schiffsrumpf, aufgebracht sein. Die erfindungsgemäße Oberflächenbeschichtung kann vorteilhafterweise durch die elektrische Schaltbarkeit des Polymerfilmaufbaus aktiv beeinflusst werden. Diese aktive Beeinflussung kann statisch oder bei verschiedenen Frequenzen erfolgen.

Erfindungsgemäß umfasst ist auch die Verwendung einer solchen elektrisch schaltbaren Oberflächenbeschichtung zur Erzeugung haptischer, akustischer und/oder optischer Signale. Dies kann zum Beispiel eine veränderbare Haptik, wie beispielsweise die Schaltung zwischen einer glatten und einer rauen Oberfläche sein. Dieser Effekt kann beispielsweise für die Selbstreinigung von Oberflächen, Enteisung von Oberflächen und fäulnisverhütende Schiffsrumpfoberflächen genutzt werden. Durch die Schaltung des erfindungsgemäßen Polymerfilmaufbaus können auch optische Eigenschaften beeinflusst werden, wodurch beispielsweise zwischen einer transparenten und einer opaken Oberfläche geschaltet werden kann.

Außerdem sind diese haptischen und optischen Effekte auch für Mensch-Maschine-Schnittstellen, beispielsweise kontextgesteuerte Menüführung, nutzbar.

Zudem ist erfindungsgemäß die Beeinflussung des Strömungsverhaltens von Fluiden möglich. Beispielsweise kann so die Erfindung zur Vermeidung von Turbulenzen oder zur Verringerung des Strömungswiderstandes verwendet werden.

Vorteilhafterweise kann somit die Erfindung in einer Vielzahl von verschiedensten Anwendungen verwirklicht werden.

Die Erfindung wird nachfolgend in beispielhafter Weise in Verbindung mit den Figuren erläutert ohne auf diese bevorzugten Ausführungsformen beschränkt zu sein.

In diesen zeigt:
Fig. 1a und Fig. 1b zeigen eine schematische Schnittansicht eines erfindungsgemäßen elektrisch schaltbaren Polymerfilmaufbaus mit einer schaltbaren elektroaktiven Polymermatrix und darin angeordneten Hartstoffpartikeln,
Fig. 2a und Fig. 2b zeigen eine schematische Schnittansicht eines erfindungsgemäßen elektrisch schaltbaren Polymerfilmaufbaus mit schaltbaren strukturgebenden Partikeln in einer Elastomermatrix,
Fig. 3a und 3b zeigen eine schematische Schnittansicht eines erfindungsgemäßen elektrisch schaltbaren Polymerfilmaufbaus mit schaltbaren strukturgebenden Partikeln in einer Elastomermatrix und strukturiert angeordneten Elektroden,
Fig. 4a und Fig. 4b zeigen eine schematische Schnittansicht eines erfindungsgemäßen elektrisch schaltbaren Polymerfilmaufbaus mit strukturiert angeordneten Elektroden und freibeweglichen Anionen und Kationen in einer Elastomermatrix.

Die gezeigten Ausführungsformen, die mit "a" bezeichnet sind, zeigen jeweils den Polymerfilmaufbau vor dem Anlegen einer elektrischen Spannung, die mit "b" bezeichneten Figuren zeigen jeweils den entsprechenden Polymerfilmaufbau nach dem Anlegen einer elektrischen Spannung.

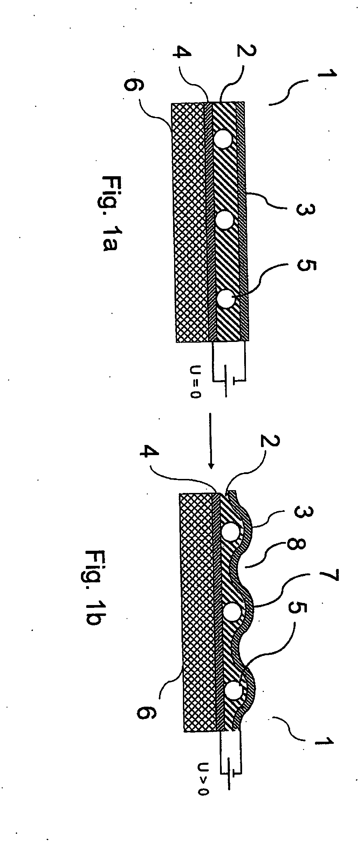

Die Fig. 1a und 1b zeigen einen erfindungsgemäßen elektrisch schaltbaren Polymerfilmaufbau 1 mit einer schaltbaren Polymermatrix 2, die zwischen flächigen Elektroden 3 und 4 eingebettet ist. Die Polymermatrix 2 kann beispielsweise aus einem dielektrischen Elastomer, beispielsweise aus Silikonelastomeren, Polyurethanelastomeren, Polyacrylatelastomeren oder Kautschuk bestehen. In der Polymermatrix 2 können weiterhin elektrisch nicht-leitfähige Hartstoffpartikel 5 als strukturgebende Partikel angeordnet sein. Nur zum Zwecke der Übersichtlichkeit sind jeweils nur drei Partikel 5 gezeigt. Diese Partikel 5 können beispielsweise aus Glas, Siliciumcarbid, Keramik oder einem harten elektrisch nicht-leitfähigen Polymer bestehen. Die Elektrode 3 ist in der gezeigten Ausführungsform als flexible Deckelektrode 3 ausgestaltet. Die Elektrode 4 ist als Basiselektrode ausgestaltet und auf einem Substrat 6 angeordnet. Wie Fig. 1a zeigt, sind die Partikel 5 so dimensioniert, dass die Polymermatrix 2 und die Deckelektrode 4 ohne angelegtes elektrisches Feld eine glatte Oberfläche aufweisen. Mit anderen Worten weist der Polymerfilmaufbau 1 eine erste glatte Oberflächenseite auf. Bei Anlegen einer Spannung wird dann, wie in Fig. 1b gezeigt, das dielektrische Elastomer zwischen den Elektroden 3, 4 zusammengedrückt, während die harten Partikel 5 ihre Form beibehalten. Die Partikel 5 sind erfindungsgemäß weiterhin so dimensioniert und auf die Dicke der Polymermatrix 2 abgestimmt, dass sich beim Anlegen einer Spannung an den Polymerfilmaufbau 1 an der ersten Oberflächenseite eine haptisch und/oder optisch wahrnehmbare Strukturierung mit Erhebungen 7 und Vertiefungen 8 ergeben kann. Unter einer wahrnehmbaren Strukturierung wird im Sinne der Erfindung verstanden, dass diese zumindest nachweisbar ist. Ein Nachweis kann beispielsweise durch optische Methoden, beispielsweise Beugung oder Brechung, erfolgen. Die Dimension und Form der Oberflächenstruktur kann vorteilhafterweise durch Größe, Form und Verteilung der harten Partikel 5, durch die Auswahl des polymeren Materials für die Polymermatrix 2 und das angelegte elektrische Feld beeinflusst und variabel eingestellt werden.

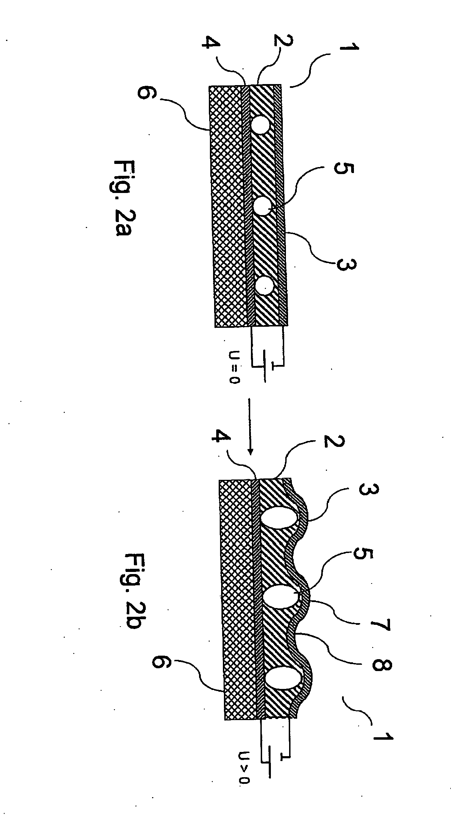

Die Fig. 2a und Fig. 2b zeigen eine schematische Schnittansicht eines erfindungsgemäßen elektrisch schaltbaren Polymerfilmaufbaus 1 mit schaltbaren Partikeln 5 in einer elastischen Polymermatrix 2. Die Elektrode 3 ist in der gezeigten Ausführungsform als flexible Deckelektrode 3 ausgestaltet. Die Elektrode 4 ist als Basiselektrode ausgestaltet und auf einem Substrat 6 angeordnet. Die Partikel 5 können beispielsweise aus ionischen EAP oder feldaktivierten EAP bestehen, die beim Anlegen einer elektrischen Spannung an die Elektroden 3, 4 eine Form- und/oder Volumenänderung vollziehen. Die Partikel 5 können eine der Elektroden 3, 4 in dem Polymeraufbau 1 berühren. Die Partikel 5 sind dabei in ihren Dimensionen so ausgelegt, dass sich bei Anlegen einer Spannung ihre Form und Verteilung über die Polymermatrix 2 durch die flexible Deckelektrode 3 abbildet und auf diese Weise eine Oberflächenstruktur mit Erhebungen 7 und Vertiefungen 8 erzeugt werden kann. Ein Vorteil dieser bevorzugten Ausgestaltung liegt darin, dass die Polymermatrix 2 nur hinsichtlich ihrer Steifigkeit so eingestellt werden muss, dass sie die Formänderung der schaltbaren Partikel 5 übernehmen und an die flexible Deckelektrode 3 weitergeben kann. Daher kommen für diese Polymerschicht 2 auch bereits bekannte Lacksysteme in Frage, die bezüglich ihrer sonstigen Eigenschaften, wie zum Beispiel Glanz, Abriebfestigkeit, Langzeitbeständigkeit und Verarbeitbarkeit schon auf spezielle technische Anwendungen abgestimmt sind. Die Elastomermatrix 2 kann in einer weiteren Ausführungsform zusätzlich zu den Partikeln 5 auch bewegliche Ionen, Anionen und/oder Kationen, enthalten. Diese beweglichen Ionen können während des Schaltvorgangs von der Polymermatrix 2 in die Partikel 5 hinein- oder herausdiffundieren, wodurch eine Form- und/oder Volumenänderung der Partikel 5 erzielt werden kann.

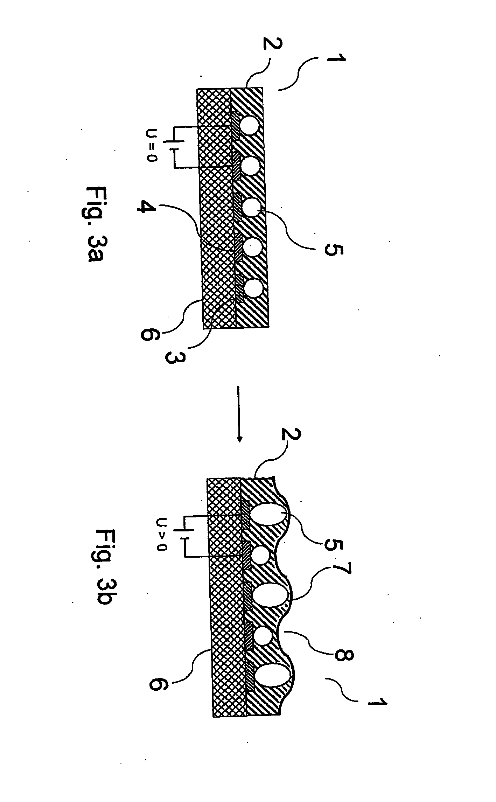

Die Figuren 3a und 3b zeigen eine schematische Schnittansicht eines erfindungsgemäßen elektrisch schaltbaren Polymerfilmaufbaus 1 mit schaltbaren strukturgebenden Partikeln 5 in einer Elastomermatrix 2 und strukturiert angeordneten Basiselektroden 3, 4. Die Elektroden 3, 4 sind alternierend angeordnet. Sie können dabei als interdigitierende Kammelektroden ausgebildet sein, die vorteilhafterweise jeweils gemeinsam gepolt werden können. Die Elektroden 3, 4 sind in dieser Darstellung in die Polymermatrix 2 eingelassen und schließen bündig mit dieser an einer Oberflächenseite ab. Diese Oberflächenseite ist auf einem Substrat 6 angeordnet. Die schaltbaren Partikel 5 können vorzugsweise aus einem ionischen EAP bestehen. Die Partikel 5 können eine der Elektroden 3, 4 in dem Polymeraufbau 1 berühren. Zum Zwecke der Übersichtlichkeit ist pro Elektrode 3, 4 jeweils nur ein Partikel 5 dargestellt. Die Partikel 5 können während des Schaltvorgangs an einer Elektrode 3 anschwellen, während die Partikel 5 an den entgegengesetzt gepolten Elektroden 4 nahezu unverändert bleiben oder schrumpfen. Die Größe der Partikel 5 wird auf die Dicke der Polymermatrix 2 zweckmäßigerweise derart abgestimmt, dass die Form- und /oder Volumenänderung der Partikel 5 durch die elektrische Schaltung auf die den Elektroden 3, 4 gegenüberliegenden Oberflächenseite übertragen wird. Die entstehenden Erhebungen 7 und Vertiefungen 8 können vorteilhafterweise die Elektrodenstrukturierung und die Verteilung der Partikel 5 wiedergeben. Die Elastomermatrix 2 kann in einer weiteren Ausführungsform zusätzlich zu den Partikeln 5 auch bewegliche Ionen, Anionen und/oder Kationen, enthalten. Diese beweglichen Ionen können während des Schaltvorgangs von der Polymermatrix 2 in die Partikel 5 hinein- oder herausdiffundieren, wodurch eine Form- und/oder Volumenänderung der Partikel 5 erzielt werden kann.

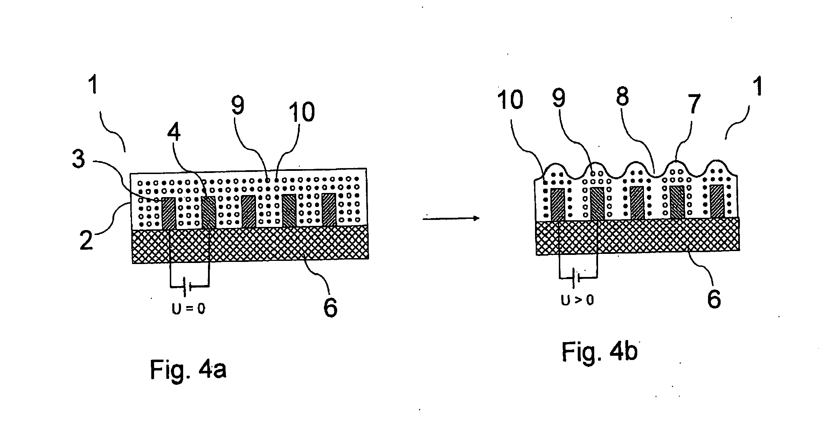

Die Figuren 4a und 4b zeigen eine schematische Schnittansicht eines erfindungsgemäßen elektrisch schaltbaren Polymerfilmaufbaus 1 mit strukturiert angeordneten Basiselektroden 3, 4 und freibeweglichen Anionen 9 und Kationen 10 in einer Elastomermatrix 2. Die Polymermatrix 2 ist dabei mit einer Oberflächenseite auf einem Substrat 6 aufgebracht. Der Polymerfilm umfassend die Polymermatrix 2 und Ionen 9, 10 des elektrisch schaltbaren Polymerfilmaufbaus 1 kann in dieser erfindungsgemäßen Ausführungsform aus einem ionenhaltigen Polymer-Komposit gebildet sein, in dem mindestens eine Ionensorte frei beweglich ist. Wird eine Spannung angelegt wandern die frei beweglichen Ionen zu den entsprechenden Elektroden. Je nachdem, ob nur eine oder, wie in den Figuren 4a und 4b gezeigt, Anionen 9 und Kationen 10 in der Polymermatrix 2 beweglich sind, schwellen in Folge der Ionendiffusion bei angelegtem elektrischen Feld die Bereiche um eine oder beide Elektrodenarten 3, 4 an und können so die Elektrodenstruktur auf der Oberflächenseite abbilden. Die Bereiche zwischen den Elektroden 3, 4 verarmen an Ionen, wodurch eine Volumenkontraktion und damit Vertiefungen 8 an der Oberflächenseite resultieren können, die den Unterschied zu den Erhebungen 7 um die entsprechenden Elektroden 3, 4 noch vergrößern. So kann auf einfache Weise eine strukturierte Oberflächenseite ausgebildet werden. Eine solche Ausgestaltung der Erfindung kann zum Beispiel durch Mischen einer ionischen Flüssigkeit in ein Polyurethan (PUR) -Matrixmaterial als Polymerfilm realisiert werden.

Durch die nachfolgend aufgeführten Beispiele soll die Erfindung weiter erläutert werden, ohne auf diese beschränkt zu sein.

### Beispiele

### Beispiel 1: Herstellung eines elektrisch schaltbaren Polymerfilmaufbaus mit strukturierten Basiselektroden.

Es wurde eine Polyurethan (PUR) -Formulierung bestehend aus 82-99 Gew.-% Desmodur® E15 (Bayer MaterialScience AG) als Isocyanat und 1 Gew.-% Triethanolamin (TEA) als Vernetzer verwendet. Um die Mischbarkeit mit ionischen Flüssigkeiten zu erhöhen wurden 0 - 17 Gew.-% Polyethylen-Glykol (PEG 600) zugesetzt, wobei sich die Bestandteile zu 100 Gew.-% ergänzen. Diese Reaktionsformulierung wurde manuell mit 1-Butyl-3-Methylimidazolium Bis(trifluormethylsulfonyl)-imid als ionische Flüssigkeit (IL) in einem Gewichtsverhältnis von 1:1 angerührt und auf Kammelektroden aufgerakelt, die bereits auf einem Substrat angeordnet waren. Die Elektroden bestanden dabei aus interdigitierenden Kupfer-Leiterbahnen mit regelmäßigen Elektrodenabständen von 0,25 mm - 4 mm, die auf einem Epoxid-Substrat (FR4) aufgetragen wurden. Die Höhe der elektrisch leitenden Cu-Elektroden über dem verwendeten Epoxid-Substrat betrug 70 µm. Die Aushärtung der Polymer-Reaktivmischung erfolgte bei einer Temperatur bis zu 60 °C. Es resultierte ein transparenter, homogener Film mit glatter Oberfläche und einer Dicke von 150 µm. Die Strom-Spannungscharakteristik der Proben einer Größe von ca. 10 cm x 10 cm wurde bei einer Spannung von 2 V untersucht. Bei Anlegen der Spannung von 2V registrierte man eine ausgeprägte Stromspitze; anschließend nahm der Strom bis zu einem konstanten Reststrom ab. Bei Abschalten der Spannung floss zunächst ein großer Strom in die entgegengesetzte Richtung, der dann asymptotisch auf 0 A zurückging. Damit keine Elektrolyse und damit kein chemischer Umwandlungsprozess erfolgten, wurde die angelegte Spannung unterhalb der elektrochemischen Potentiale der Ionen der ionischen Flüssigkeit und der Polyurethan-Matrix gehalten. Die spannungsinduzierte Wanderung der Ionen in der PUR-Matrix verlief auf einer Zeitskala von Sekunden und war reversibel schaltbar. Die Schaltung der Oberflächenstruktur des erfindungsgemäßen Polymerfilmaufbaus durch die Ionenwanderung innerhalb des PUR-Films konnte anhand der Verschiebung eines an der Oberflächenseite des erfindungsgemäßen Polymerfilmaufbaus reflektierten Laserstrahls beobachtet werden.

### Beispiel 2:

In einem weiteren Versuch wurde ein 2K-Polyurethan als Polymermatrix verwendet, das unter der Bezeichnung "ISO-PUR A 776" von der ISO-Elektra GmbH als "selbstheilendes Gel" erhältlich ist. Dieses wurde analog zu Beispiel 1 in einem Gewichtsverhältnis von 1:1 mit Methylethylimidazolium-Octylsulfat als ionische Flüssigkeit versetzt. Die Mischung wurde wie in Beispiel 1 beschrieben als Film auf ein Substrat mit darauf angeordneten interdigitierenden Basiselektroden aufgebracht und durch ein elektrisches Feld geschaltet. Die Verschiebung eines an der Oberflächenseite des erfindungsgemäßen Polymerfilmaufbaus reflektierten Laserstrahls wurde beim Anlegen einer Spannung von 2 V an dieses sehr weiche PUR-IL-Komposit stärker verändert als bei der unter Beispiel 1 beschriebenen PUR-Formulierung. Hieraus konnte abgeleitet werden, dass sich die Oberflächenstruktur dieses erfindungsgemäßen elektrisch schaltbaren Polymerfilmaufbaus vergleichsweise stärker verändert.

Zusammenfassend werden erfindungsgemäß elektrisch schaltbare Polymerfilmaufbauten bereitgestellt, mit denen die Struktur von Oberflächen und Oberflächenbeschichtungen aktiv geschaltet und beeinflusst werden können.

Durch die variable Einstellbarkeit der Eigenschaften der erfindungsgemäßen elektrisch schaltbaren Polymerfilmaufbauten können diese vorteilhafterweise auf die verschiedensten Anforderungen von speziellen Anwendungen angepasst werden.

## Patentansprüche

1. Elektrisch schaltbarer Polymerfilmaufbau, der eine erste und eine zweite Oberflächenseite aufweist, die einander gegenüberliegend angeordnet sind, umfassend mindestens ein Elektrodenpaar bestehend aus Anode und Kathode und eine Polymermatrix **dadurch gekennzeichnet, dass** in der Polymermatrix gegebenenfalls strukturgebende Partikel angeordnet sind und die Polymermatrix und/oder die gegebenenfalls vorhandenen strukturgebenden Partikel aus einem elektroaktiven Polymer bestehen, wobei durch eine elektrische Schaltung des elektroaktiven Polymers die erste und/oder die zweite Oberflächenseite von einem glatten Zustand in einen strukturierten Zustand überführt wird.

2. Elektrisch schaltbarer Polymerfilmaufbau nach Anspruch 1 **dadurch gekennzeichnet, dass** das elektroaktive Polymer ein feldaktiviertes oder ein ionisches elektroaktives Polymer ist.

3. Elektrisch schaltbarer Polymerfilmaufbau nach Anspruch 1 **dadurch gekennzeichnet, dass** er in glattem Zustand eine Dicke von ≥10 µm und ≤1mm aufweist.

4. Elektrisch schaltbarer Polymerfilmaufbau nach Anspruch 1 **dadurch gekennzeichnet, dass** die Anode und Kathode auf einander gegenüberliegenden Oberflächen der Polymermatrix angeordnet sind und eine Oberflächenseite des Polymerfilmaufbaus als flexible Deckelektrode und die jeweils andere Oberflächenseite als starre Basiselektrode ausgebildet ist.

5. Elektrisch schaltbarer Polymerfilmaufbau nach Anspruch 1 **dadurch gekennzeichnet, dass** Anoden und Kathoden auf einander gegenüberliegenden Oberflächen der Polymermatrix angeordnet sind und die Elektroden an einer oder an beiden Oberflächenseiten des Polymerfilmaufbaus strukturiert angeordnet sind.

6. Elektrisch schaltbarer Polymerfilmaufbau nach Anspruch 1 **dadurch gekennzeichnet, dass** die Anode und Kathode als Basiselektroden ausgebildet und an der ersten oder an der zweiten Oberflächenseite strukturiert angeordnet sind.

7. Elektrisch schaltbarer Polymerfilmaufbau nach Anspruch 1 **dadurch gekennzeichnet, dass** die Polymermatrix aus einem elektroaktiven Polymer besteht und die strukturgebenden Partikel elektrisch nicht-leitfähige Hartstoffpartikel sind.

8. Elektrisch schaltbarer Polymerfilmaufbau nach Anspruch 7 **dadurch gekennzeichnet, dass** die Hartstoffpartikel aus Glas, Keramik, oder einem elektrisch nicht leitfähigen polymeren Material bestehen.

9. Elektrisch schaltbarer Polymerfilmaufbau nach Anspruch 6 **dadurch gekennzeichnet, dass** die Polymermatrix aus einem ionischen elektroaktiven Polymer besteht und keine strukturgebenden Partikel in der Polymermatrix angeordnet sind.

10. Elektrisch schaltbarer Polymerfilmaufbau nach Anspruch 9 **dadurch gekennzeichnet, dass** die Polymermatrix aus einem ionenhaltigen Elastomeren besteht.

11. Elektrisch schaltbarer Polymerfilmaufbau nach Anspruch 1 **dadurch gekennzeichnet, dass** die strukturgebenden Partikel aus einem elektroaktiven Polymer bestehen und die Polymermatrix aus einem Elastomeren gebildet wird.

12. Elektrisch schaltbarer Polymerfilmaufbau nach Anspruch 1 **dadurch gekennzeichnet, dass** die erste oder die zweite Oberflächenseite auf einem Substrat aufgebracht ist, wobei die jeweils andere Oberflächenseite durch die elektrische Schaltung des elektroaktiven Polymers in einen strukturierten Zustand überführt wird.

13. Elektrisch schaltbare Oberflächenbeschichtung umfassend einen elektrisch schaltbaren Polymerfilmaufbau nach Anspruch 1.

14. Verwendung einer elektrisch schaltbaren Oberflächenbeschichtung nach Anspruch 13 als selbstreinigende Oberflächenbeschichtung, als fäulnisverhütende Oberflächenbeschichtung, selbstenteisende Oberflächenbeschichtung und/oder zur Beeinflussung des Strömungsverhaltens von Fluiden.

15. Verwendung einer elektrisch schaltbaren Oberflächenbeschichtung nach Anspruch 13 zur Erzeugung haptischer, akustischer und/oder optischer Signale.
